# EUROPEAN PATENT SPECIFICATION

(11) **EP 0 578 337 B1**
(45) Date of publication and mention of the grant of the patent: **30.10.1996**
(21) Application number: 93202604.0
(22) Date of filing: 19.04.1988
(51) Int. Cl.: H01P 1/22

(54) **Microwave absorber attenuator for linear SSPA power control**
Absorbierendes Mikrowellen-Dämpfungsglied zur Leistungsregelung eines linearen Festkörperleistungsverstärkers
Attenuateur absorbeur de micro-ondes pour commande de puissance linéaire d'amplificateur de puissance à semi-conducteurs

(30) Priority: 04.05.1987 US 45414
(43) Date of publication of application: 12.01.1994
(62) Divisional of application: 88905262.7
(73) Proprietor: AT&T Corp., New York, NY 10013-2412 (US)
(72) Inventor: McGann, William E., Satellite Beach, FL 32937 (US); Todd, John R., Palm Bay, FL 32905 (US)
(74) Representative: Watts, Christopher Malcolm Kelway, Dr.

(56) References cited:
- US-A- 2 898 561
- US-A- 4 160 220
- Bell Telephone System, Monograph B - 1571, Technical Publications, 1948, New York US; G. K. TEAL et al.: "Microwave Attenuator Materials and their Applications"
- EDN ELECTRICAL DESIGN NEWS vol. RT-119, no. 9 , September 1964 , NEWTON, MASSACHUSETTS US pages 6 - 7 - 'Waveguide Hardware'

## Description

### Field of the Invention

The present invention relates to absorbers suitable for use in attenuators for satellite communication systems, and particularly controlling the output power of a microwave solid state power amplifier.

### Background of the Invention

Because of its low cost and compact size, the solid state (GaAs) power amplifier (SSPA) is a commonly employed component of the uplink transmitter of a VSAT (very small aperture terminal) ku band earth station. The (gain) transfer (power output vs. power input) characteristic of a typical SSPA has a positive sloped linear region which gradually decreases over a knee portion to a slightly negative-sloped saturation region. When driven at the 1.0dB gain compression point, namely at that point on the knee of the transfer characteristic which is 1dB below an extension of its linear, positive slope region, the frequency response of the SSPA has a substantially smooth profile over its intended operational range.

For currently available SSPAs the output power at the 1dB gain compression point is on the order of two watts, which may be considerably greater than the power required by the link (e.g., one watt). Consequently, it is necessary to reduce the output power transmitted by the uplink terminal.

It is an object of the invention to provide an absorber for such use.

G.K. Teal et al., in 'Microwave Attenuator Materials and their Applications', Monograph B-1571, Bell Telephone Systems Technical Publications, 1948, disclose microwave attenuators consisting of bodies of energy-absorbing material of a variety of shapes, including that set out in the preamble of claim 1.

US-A-4,160,220 mentions the ECCOSORB material, namely used as an absorber.

US-A-2,898,561 discloses an attenuator for a waveguide which comprises an insulating plate bearing a resistive layer which is inserted into a slot in the side of a waveguide.

### Summary of the Invention

According to the invention there is provided an absorber as set out in claim 1. Preferred forms of the invention are set out in claims 2 to 4.

### BRIEF DESCRIPTION OF THE DRAWINGS

Figure 1 is a diagrammatic illustration of a VSAT power amplifier section incorporating a waveguide attenuator in accordance with the present invention;
Figures 2 and 3 are respective sectional side and end views of the attenuator waveguide section 14 shown in Figure 1 depicting the manner in which the attenuator element is inserted into the waveguide section; and
Figure 4 is a cross-sectional view of the attenuator element 33 employed in the attenuator waveguide section shown in Figures 2 and 3.

### DETAILED DESCRIPTION

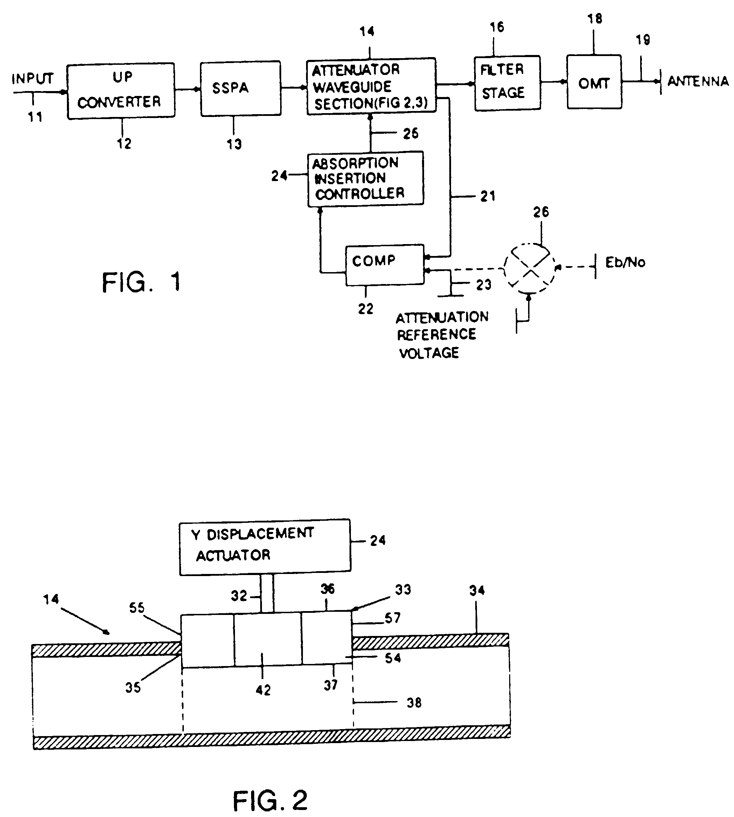

Referring now to Figure 1, there is illustrated a schematic block diagram of a power control section containing a solid-state power amplifier and attenuator waveguide section incorporated in the up-converter circuitry between the IF input and RF output of a VSAT earth station.

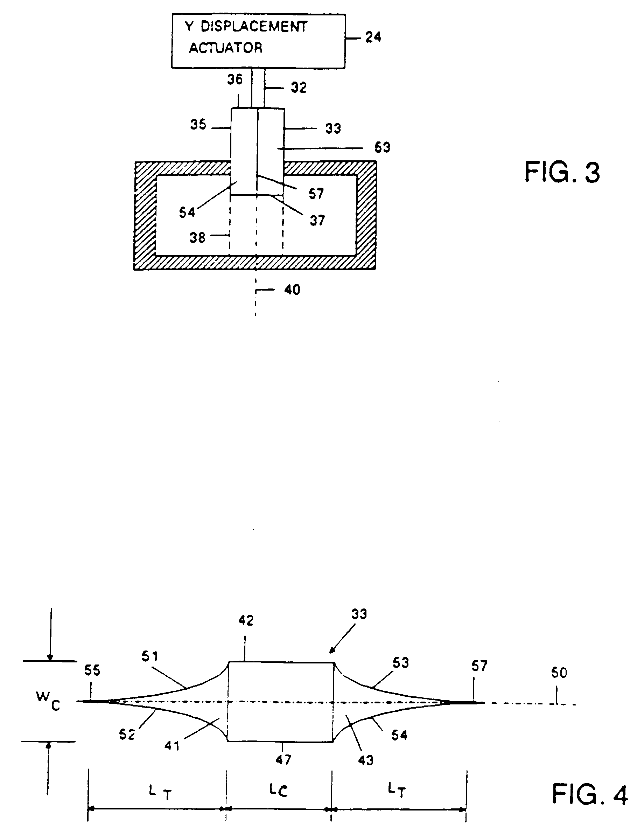

More specifically, an input signal (e.g. an intermediate frequency signal having a frequency of 140MHz) is coupled to an up-converter 12 of the earth station transmitter. The output of up-converter 12 has a frequency corresponding to the transmission frequency of the earth terminal, as beamed from the earth terminal antenna to the satellite. For purposes of the present description, it will be assumed that this output frequency lies in a Ku band range of 14.0-14.5GHz. The up-converter 12 is coupled to a solid state power amplifier (SSPA) 13, the output of which is coupled to an attenuator waveguide section 14, the details of which will be described below in conjunction with the description of Figures 2 and 3. Attenuator waveguide section 14 serves to controllably attenuate the output of SSPA 13 to the level required by the satellite link. As mentioned briefly above, SSPA 13 is operated at its 1dB gain compression point so that its frequency response is substantially flat over the range of frequencies of interest (e.g. 14.0-14.5GHz).

The output of waveguide section 14 is coupled through a waveguide filter stage 16 to an orthomode transducer 18. Waveguide filter stage 16 is comprised of a pair of cascaded filters, specifically a harmonic output rejection filter for SSPA 13 and a receive band noise power rejection filter. The output of orthomode transducer 18 is coupled over link 19 to an antenna feedhorn (not shown).

As mentioned above, the behavioral characteristics of a typical SSPA 13 are such that its gain varies considerably with a change in frequency when operated below its 1dB gain compression point. Pursuant to the present invention, SSPA 13 is operated at its 1dB gain compression point so that its output characteristic is substantially flat over the frequency range of interest. For present day VSAT stations, operating in the Ku band, the output power of the terminal may be on the order of several watts or less. (Typically, for a commercially available gallium arsenide SSPA, its 1dB gain compression point produces an output on the order of two watts.) The power required by the satellite link can be expected to be between one and two watts, so that the output of the SSPA must be reduced. Pursuant to the present invention, rather than reduce the input to the SSPA, which would certainly reduce its output, but would do so by, driving the operational state of the SSPA to a gain level that results in a very nonlinear frequency response, the present invention operates the SSPA at a gain where its frequency response is substantially flat (for example at its 1dB gain compression point) and attenuates the substantially full power output level of the SSPA.

For this purpose, as shown in Figure 1, the output of attenuator waveguide section 14 is coupled over link 21 to a comparator 22. A second input of comparator 22 is coupled over link 23 to an attenuation reference voltage, corresponding to the desired power level on the satellite output link.

Such an attenuation reference voltage may be derived directly from a manually set voltage source or from a voltage combining circuit (e.g. summing circuit), shown in broken lines at 26 in Figure 1, the output of which represents the sum or (or difference between) the manually set voltage and one or more monitored system parameters, such as a signal representative of E_{b}/Nₒ used for uplink power control for compensating for a reduction in signal level (e.g. rain fade at the local site). The difference between the actual output produced by attenuator section 14 and the desired level produces a signal at the output of comparator 22 which is supplied to an attenuator insertion controller 24. Attenuator insertion controller 24 is essentially comprised of a linear DC actuator which controls the insertion of a ferrite attenuator element to be described below into waveguide section 14.

More particularly, with reference to Figures 2 and 3, attenuator waveguide section 14 is shown as comprising a rectangular waveguide 34 having a slot 35 at the top thereof which is sized to accommodate a tapered ferrite attenuator element 33. Element 33 is coupled to one end of the output displacement arm of linear DC actuator 24, shown diagrammatically at 32 in Figures 2 and 3. As mentioned above, linear actuator 24 displaces its output arm 32 in accordance with the differential signal supplied at the output of comparator 22. The displacement of output arm 32 and, consequently, the degree of insertion of attenuator element 33 through slot 35 in waveguide 34 controls the degree of absorption of the 14.5-15.0GHz electromagnetic wave travelling through the waveguide. For maximum absorption control, slot 35 is preferably situated in a direction parallel with the longitudinal axis (the z axis) of the waveguide and symmetrical about a center line 40 of the waveguide. The attenuator element itself is preferably comprised of a microwave absorber material that offers both strength and heat dissipation robustness with respect to the electromagnetic energy which is coupled through the waveguide section 34.

For this purpose, element 33 may comprise a tapered blade of magnetically loaded epoxide, such as ECCOSORB MF materials manufactured by Emerson and Cuming. For purposes of the present embodiment, it may be assumed that ECCOSORB MF 117 type material may be employed as absorber element 33.

As shown in the cross-sectional view of Figure 4, the physical configuration of the absorber element is such that it is symmetrically tapered at regions 41 and 43 about a vertical plane line 50 which is intended to be coincident with the center line 40 of waveguide section 14 when the absorber is inserted into slot 35 at the top of the waveguide shown in Figures 2 and 3. Region 41 has a pair of tapered faces 51 and 52 which extend from a pair of parallel sidewalls 46 and 47 and taper to a point 55 at one end of the absorber. At the other end of the absorber, region 43, which is contiguous with a central region 42 of the absorber, has a pair of tapering side faces 53 and 54 which extend to an edge 57. For minimizing the VSWR, the tapering of faces 51-54 follows a Tschebyscheff binomial taper. The length L_{T} of regions 41 and 43 and the length of L_{C} of central region 42 between tapered regions 41 and 43, as well as the width or thickness W_{C} of central region 42 of absorber blade 33, depends upon the size of the waveguide, the frequency of the energy being absorbed, the degree of absorption to be obtained, any external cooling that may be supplied, etc.

Because the leading and trailing edges 55 and 57, respectively, of the absorber blade 33 are narrowed to a point and the absorber is tapered away from those edges towards its thickness in the central region of the absorber, the electromagnetic wave travelling through the waveguide does not abruptly encounter the absorber material, thereby minimizing its effect on the voltage standing wave ratio.

As shown in Figures 2 and 3, the top and bottom surfaces 36 and 37 of absorber 33 are substantially parallel to the top and bottom surfaces of the waveguide 34, the separation between which corresponds to the interior height or b dimension of the waveguide 34, Thus, maximum absorption is provided when the absorber 33 is inserted fully into the waveguide and extends from the top interior surface of the waveguide to the bottom interior surface thereof as delineated by broken lines 38 in Figures 2 and 3. For the parametric values recited here, it has been found that the absorber can provide approximately 100dB of absorption capability when fully inserted into the waveguide. However, in practical use, the range of absorption is on the order of 0-15dB, to provide the transmitter output power levels mentioned previously.

To form an individual absorber element, a sheet or bar of the absorber material, such as the ECCOSORB MF series of material, manufactured by Emerson & Cuming, may be individually cut and machined to provide the requisite cross-section. Preferably, however, the absorber material, which basically comprises a steel carbonyl microsphere paste, is formed into the prescribed state of molding. This permits the absorber blade element to be inexpensively mass-produced.

Advantageously, the absorber configuration of the present invention is a cost effective alternative to the look-up table frequency response correction scheme for correcting for the nonlinearity of the operation of the SSPA as described in the above-referenced copending application. The present invention may be incorporated into the system described in that application and, in so doing, the monitor and control processor and associated memory through which the frequency response correction is carried out can be eliminated. Specifically, the present invention is inserted at the downstream end of the SSPA, as shown in Figure 1, while the temperature correction and down link AGC correction networks are retained at the upstream end of the link. The SSPA is operated at its 1dB compression point to obtain the essentially flat frequency response characteristic.

Controlled insertion of the absorber element into a section of slotted waveguide thereby offers a simple and relatively inexpensive mechanical expedient to the electronically implemented look-up table tracking procedure of the system described in the foregoing application. When combined with the temperature controlled network and downlink AGC correction circuitry, the present invention equips the VSAT with a cost effective power control mechanism for simplifying adjustment of SSPA output power. For maximizing utility of the control network, accordingly, it is preferred that the temperature control and AGC downlink control portions of the system described in the copending application, which form an upstream input controller to the SSPA, be combined with the downstream attenuator absorber mechanism of the present invention.

## Claims

1. An electromagnetic wave absorber comprising a body of electromagnetic energy absorbent material, said body comprising a central body section (42) opposite surfaces (46,47) of which are substantially parallel to one another and a pair of tapered body sections (41,43) extending from said central body section, each of said tapered body sections having a pair of surfaces (51,52;53,54) respectively tapered from the parallel opposite surfaces of said central body section to an edge portion (55,57) thereof, CHARACTERISED IN THAT
each of the tapered surfaces of each of said tapered body sections has an effectively exponential varying slope between a parallel opposite surface and an edge portion.

2. An electromagnetic wave absorber according to claim 1 wherein the entirety of said central body section and said tapered body sections are made of a ferrite-based electromagnetic energy absorbent material.

3. An electromagnetic wave absorber according to claim 1 or claim 2, further comprising a section of waveguide (34) having an aperture (35) in a wall portion thereof and means (29,32) for controllably inserting said body of electromagnetic energy absorbent material through said aperture into the cavity of said section of waveguide.

4. An electromagnetic wave absorber according to claim 3, wherein said body is arranged to be inserted into the cavity of said section of waveguide such that said tapered body sections extend in the longitudinal direction of said section of waveguide.

## Patentansprüche

1. Absorber für elektromagnetische Wellen, der einen Körper aus elektromagnetische Energie absorbierendem Material umfaßt, wobei der Körper einen zentralen Körperabschnitt (42) umfaßt, dessen gegenüberliegende Oberflächen (46, 47) im wesentlichen parallel zueinander sind, sowie ein Paar spitz zulaufender Körperabschnitte (41, 43), die sich von dem zentralen Körperabschnitt ab erstrecken, wobei jeder der spitz zulaufenden Körperabschnitte ein Paar Oberflächen (51,52; 53, 54) aufweist, die jeweils von den parallel gegenüberliegenden Oberflächen des zentralen Körperabschnitts zu einem Kantenbereich (55, 57) hiervon hin spitz zulaufen, dadurch gekennzeichnet, daß
jede spitz zulaufende Oberfläche jedes der spitz zulaufenden Körperabschnitte zwischen einer parallel gegenüberliegenden Oberfläche und einem Kantenbereich eine sich effektiv entsprechend einer Exponentialkurve verändernde Steigung aufweist.

2. Absorber für elektromagnetische Wellen nach Anspruch 1, wobei die Gesamtheit des zentralen Körperabschnitts und der spitz zulaufenden Körperabschnitte aus einem auf Ferrit beruhenden, elektromagnetische Energie absorbierendem Material hergestellt ist.

3. Absorber für elektromagnetische Wellen nach Anspruch 1 oder Anspruch 2, der außerdem einen Wellenleiterabschnitt (34) mit einer Öffnung (35) in einem Wandteil hiervon umfaßt sowie Mittel (29, 32) zum kontrollierbaren Einführen des Körpers aus elektromagnetische Energie absorbierendem Material durch die Öffnung in den Hohlraum des Wellenleiterabschnitts.

4. Absorber für elektromagnetische Wellen nach Anspruch 3, wobei der Körper so angeordnet ist, daß er in den Hohlraum des Wellenleiterabschnitts so eingesetzt werden kann, daß die spitz zulaufenden Körperabschnitte sich in Längsrichtung des Wellenleiterabschnitts erstrecken.

## Revendications

1. Absorbeur d'ondes électromagnétiques comportant un corps de matière absorbant l'énergie électromagnétique, ledit corps comprenant une section de corps médiane (42) dont des surfaces opposées (46, 47) sont sensiblement parallèles l'une à l'autre et une paire de sections de corps allant en s'effilant (41, 43) partant de ladite section de corps médiane, chacune desdites sections de corps allant en s'effilant présentant une paire de surfaces (51, 52; 53, 54) respectivement inclinées à partir des surfaces opposées parallèles de ladite section de corps médiane jusqu'à une partie de bord d'effilement (55, 57) de celle-ci, caractérisé en ce que
chacune des surfaces inclinées de chacune desdites sections de corps allant en s'effilant présente une pente variant effectivement exponentiellement entre une surface opposée parallèle et une partie de bord d'effilement.

2. Absorbeur d'ondes électromagnétiques suivant la revendication 1, dans lequel ladite section de corps médiane et lesdites sections de corps allant en s'effilant sont entièrement faites d'une matière absorbant l'énergie électromagnétique à base de ferrite.

3. Absorbeur d'ondes électromagnétiques suivant la revendication 1 ou 2, comportant en outre une section de guide d'ondes (34) présentant une ouverture (35) ménagée dans une partie de paroi de cette section et des moyens (29, 32) destinés à insérer de manière réglable ledit corps de matière absorbant l'énergie électromagnétique à travers ladite ouverture dans la cavité de ladite section de guide d'ondes.

4. Absorbeur d'ondes électromagnétiques suivant la revendication 3, dans lequel ledit corps est agencé de manière à être inséré dans la cavité de ladite section de guide d'ondes de telle sorte que lesdites sections de corps allant en s'effilant s'étendent dans la direction longitudinale de ladite section de guide d'ondes.
